# EUROPEAN PATENT SPECIFICATION

(11) **EP 2 497 814 B1**
(45) Date of publication and mention of the grant of the patent: **01.04.2015**
(21) Application number: 11183601.1
(22) Date of filing: 30.09.2011
(51) Int. Cl.: C09K 11/77, H01L 33/50

(54) **Fluorescent substance and light-emitting device employing the same**
Fluoreszierende Substanz und lichtemittierende Vorrichtung, die diese Substanz einsetzt
Substance fluorescente et dispositif électroluminescent l'utilisant

(30) Priority: 09.03.2011 JP 2011051164; 20.09.2011 JP 2011205182
(43) Date of publication of application: 12.09.2012
(73) Proprietor: Kabushiki Kaisha Toshiba, Minato-ku Tokyo (JP)
(72) Inventor: Kato, Masahiro, Minato-ku, Tokyo (JP); Fukuda, Yumi, Minato-ku, Tokyo (JP); Okada, Aoi, Minato-ku, Tokyo (JP)
(74) Representative: Granleese, Rhian Jane

(56) References cited:
- EP-A1- 2 432 037
- EP-A2- 2 361 960
- WO-A1-2011/024882
- US-A1- 2010 025 632
- US-A1- 2010 102 707

## Description

### CROSS-REFERENCE TO RELATED APPLICATIONS

This application is based upon and claims the benefit of priority from the prior Japanese Patent Application Nos. 2011-051164, filed on March 9, 2011 and 2011-205182, filed on September 20, 2011.

### FIELD

The embodiment relates to a fluorescent substance excellent in quantum efficiency and also to a light-emitting device employing that substance.

### BACKGROUND

LED light-emitting devices, which utilize light-emitting diodes, are used in many displaying elements of instruments such as mobile devices, PC peripheral equipments, OA equipments, various kinds of switches, light sources for backlighting, and indicating boards. The LED light-emitting devices are strongly required not only to have high efficiencies, but also to be excellent in color rendition when used for general lighting or to deliver wide color gamuts when used for backlighting. In order to enhance the efficiencies of light-emitting devices, it is necessary to improve those of fluorescent substances used therein. In addition, from the viewpoint of realizing high color rendition or a wide color gamut, it is preferred to adopt a white light-emitting device that comprises a combination of a blue light-emitting excitation source, a fluorescent substance emitting green luminescence under excitation by blue light, and another fluorescent substance emitting red luminescence under excitation by blue light.

Meanwhile, high load LED light-emitting devices generate heat in operation so that fluorescent substances used therein are generally heated to about 100°C to 200°C. When thus heated, the fluorescent substances generally lose emission intensity. Accordingly, it is desired to provide a fluorescent substance less undergoing the decrease of emission intensity (temperature quenching) even if the temperature rises considerably.

Eu-activated alkaline earth orthosilicate phosphors are typical examples of fluorescent substances emitting green or red luminescence under excitation by blue light, and hence are preferably used in the aforementioned LED light-emitting devices. The green light-emitting fluorescent substance of that phosphor shows, for example, luminance characteristics such as an absorption ratio of 73%, an internal quantum efficiency of 85% and a luminous efficiency of 62% under excitation by light at 460 nm; and the red light-emitting one of that phosphor shows, for example, luminance characteristics such as an absorption ratio of 82%, an internal quantum efficiency of 66% and a luminous efficiency of 54% under excitation by light at 460 nm. A LED light-emitting device comprising those in combination gives white light with such a high efficiency and such a high color gamut as to realize 186 lm/W based on the excitation light and a general color rendering index Ra=86, respectively.

However, if those Eu-activated alkaline earth orthosilicate phosphors are used in a high load LED light-emitting device, they often undergo the above-described decrease of emission intensity. Specifically, when the temperature rises, those fluorescent substances remarkably suffer from the temperature quenching but the blue LED is not so affected that the emission intensity thereof decreases only slightly. Consequently, the resultant light radiated from the device is liable to lose the balance between the emission from the blue LED and the luminescence from the fluorescent substances. Further, since the temperature quenching acts in different manners on the green and red light-emitting fluorescent substances, it often becomes difficult to keep the balance between green and red colors in the resultant light in accordance with increase of the load. As a result, there is a problem of serious color discrepancies caused by loss of the balance among the blue, green and red emissions.

### BRIEF DESCRIPTION OF THE DRAWINGS

Figure 1 is an X-ray diffraction pattern of the fluorescent substance according to one aspect of the embodiment.
Figure 2 shows a vertical sectional view schematically illustrating a light-emitting device utilizing a fluorescent substance according to one aspect of the embodiment.
Figure 3 shows emission spectra of the green light-emitting fluorescent substances produced in Examples 1 to 4 under excitation by light at 460 nm.
Figure 4 shows graphs giving temperature characteristics of the fluorescent substances used in Example 1.
Figure 5 shows a vertical sectional view schematically illustrating a light-emitting device produced in Example 1.
Figure 6 shows an emission spectrum of the light-emitting device produced in Example 1.
Figure 7 shows a relation between the chromaticity point (2 degree field of view) and the drive current with regard to the light-emitting device produced in Example 1
Figure 8 shows an emission spectrum of the light-emitting device produced in Example 2.
Figure 9 shows a relation between the chromaticity point (2 degree field of view) and the drive current with regard to the light-emitting device produced in Example 2.
Figure 10 shows an emission spectrum of the light-emitting device produced in Example 3.
Figure 11 shows a relation between the chromaticity point (2 degree field of view) and the drive current with regard to the light-emitting device produced in Example 3.
Figure 12 shows graphs giving temperature characteristics of the fluorescent substances used in Example 4.
Figure 13 shows an emission spectrum of the light-emitting device produced in Example 4.
Figure 14 shows a relation between the chromaticity point (2 degree field of view) and the drive current with regard to the light-emitting device produced in Example 4.
Figure 15 shows an emission spectrum of the light-emitting device produced in Example 5.
Figure 16 shows a relation between the chromaticity point (2 degree field of view) and the drive current with regard to the light-emitting device produced in Example 5.
Figure 17 shows an emission spectrum of the light-emitting device produced in Example 6.
Figure 18 shows a relation between the chromaticity point (2 degree field of view) and the drive current with regard to the light-emitting device produced in Example 6.
Figure 19 shows graphs giving temperature characteristics of the fluorescent substances used in Example 7.
Figure 20 shows an emission spectrum of the light-emitting device produced in Example 7.
Figure 21 shows a relation between the chromaticity point (2 degree field of view) and the drive current with regard to the light-emitting device produced in Example 7.
Figure 22 shows an emission spectrum of the green light-emitting fluorescent substance produced in Comparative Example 1 under excitation by light at 460 nm.
Figure 23 shows graphs giving temperature characteristics of the fluorescent substances used in Comparative Example 1.
Figure 24 shows an emission spectrum of the light-emitting device produced in Comparative Example 1.
Figure 25 shows a relation between the chromaticity point (2 degree field of view) and the drive current with regard to the light-emitting device produced in Comparative Example 1.
Figure 26 shows a relation between the luminous efficiency and the half-width of X-ray diffraction peak with regard to the green light-emitting fluorescent substance produced in each Example and Comparative Example.
Figure 27 shows graphs giving temperature characteristics of the fluorescent substances used in Comparative Example 2.
Figure 28 shows an emission spectrum of the light-emitting device produced in Comparative Example 2.
Figure 29 shows a relation between the chromaticity point (2 degree field of view) and the drive current with regard to the light-emitting device produced in Comparative Example 2.

### DETAILED DESCRIPTION

Embodiments will now be explained with reference to the accompanying drawings.

The present inventors have found that a green light-emitting fluorescent substance showing high quantum efficiency, giving strong emission intensity and having such favorable temperature characteristics that the emission intensity less decreases even if the temperature rises can be obtained by incorporating an emission center element into a particular oxynitride fluorescent substance whose crystal structure and composition are both restricted. Further, the present inventors have also found that a light-emitting device less undergoing color discrepancies even when operated with high power, namely, even at a high temperature, can be obtained by adopting the above green light-emitting fluorescent substance in combination with a particular red light-emitting one.

The following explains a green light-emitting fluorescent substance according to the embodiment and also a light-emitting device employing that fluorescent substance.

### Green light-emitting fluorescent substance

A green light-emitting fluorescent substance (G) according to one aspect of the present embodiment is represented by the following formula (1):

(Sr₁₋ₓEuₓ)_{3-y}Al_{3+z}Si_{13-z}O₂₊ᵤN_{21-w} (1)

in which x, y, z, u and w are numbers satisfying the conditions of 0<x<1, -0.1≤y≤0.3, -3≤z≤1 and -3<u-w≤1.5, respectively.

The element Sr is preferably replaced with the emission center element Eu in an amount of 0.1 mol% or more. If the amount is less than 0.1 mol%, it is difficult to obtain sufficient luminescence. The element Sr may be completely replaced with the mission center element Eu, but decrease of the emission probability (concentration quenching) can be avoided as much as possible if the replaced amount is less than 50 mol%.

As shown in the formula (1), the green light-emitting fluorescent substance of the present embodiment basically comprises Sr, Eu, Al, Si, O and N. However, the substance may contain small amounts of impurities unless they impair the effect of the embodiment. The impurities may be originally contained in the starting materials or may come in during the procedures of the production process. Examples of the impurity elements include Na, Ba, Ca, Mg, Cu, Fe, Pb, Cl, C and B. However, even if they may be contained, the amount thereof is not more than 0.2%, preferably not more than 300 ppm.

The green light-emitting fluorescent substance (G) of the embodiment emits blue to green luminescence, namely, luminescence having a peak in the wavelength range of 490 to 580 nm when excited by light in the wavelength range of 250 to 500 nm.

Furthermore, x, y, z, u and w are numbers satisfying the conditions of:
0<x≤1, preferably 0.001≤x≤0.5,
-0.1≤y≤0.3, preferably -0.1≤y≤0.15, more preferably -0.09≤y≤0.07,
-3≤z≤1, preferably -1≤z≤1, more preferably 0.2≤z≤1, and
-3<u-w≤1.5, preferably -1 <u-w≤1, more preferably -0.1 ≤u-w≤0.3, respectively.

The green light-emitting fluorescent substance according to the embodiment is based on an inorganic compound having essentially the same crystal structure as Sr₃Al₃Si₁₃O₂N₂₁. However, the constituting element thereof is partly replaced with the luminance element and the content of each element is regulated in a particular range, and thereby it can be made possible for the substance to show high quantum efficiency and to have such favorable temperature characteristics that the substance less undergoes the temperature quenching when used in a light-emitting device. Hereinafter, this kind of crystal is often referred to as "Sr₃Al₃Si₁₃O₂N₂₁-type crystal".

The crystal of Sr₃Al₃Si₁₃O₂N₂₁, belongs to the orthorhombic system, and the lattice constants thereof are a=14.76 A, b=7.46 A and c=9.03 A.

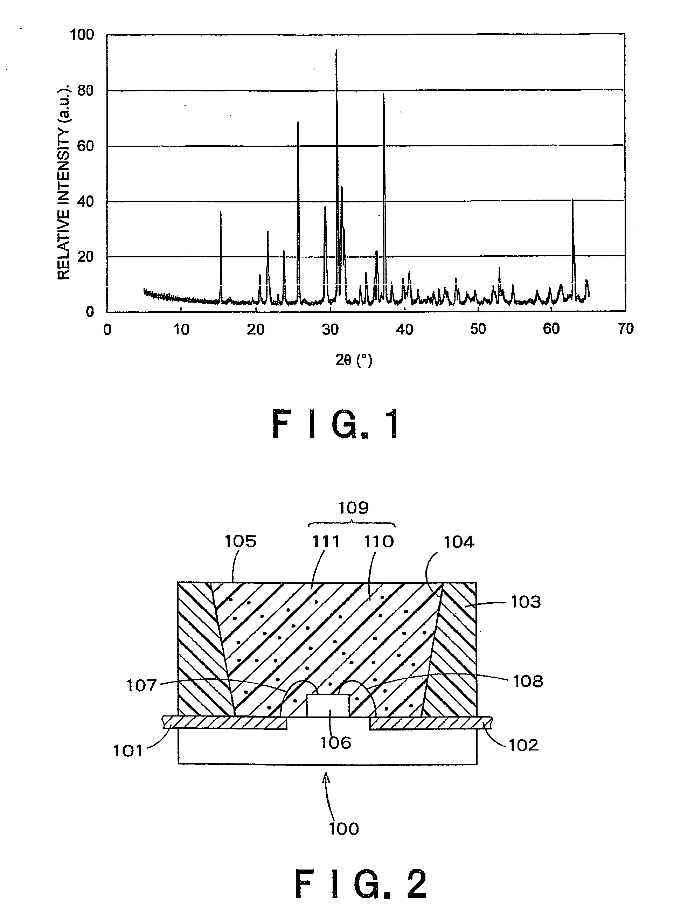

The fluorescent substance according to the embodiment can be identified by X-ray diffraction or neutron diffraction. An typical X-ray diffraction pattern of the fluorescent substance according to one aspect of the embodiment is shown in Figure 1. This means that the present embodiment includes not only a substance exhibiting the same X-ray diffraction pattern as Sr₃Al₃Si₁₃O₂N₂₁ but also a substance having a crystal structure in which the constituting elements are so replaced with other elements as to change the lattice constants within particular ranges. The constituting elements of Sr₃Al₃Si₁₃O₂N₂₁ crystal may be replaced with other elements in such a way described below in detail. Specifically, Sr in the crystal may be replaced with the emission center element Eu; the site of Si may be filled with one or more elements selected from the group consisting of tetravalent elements such as Ge, Sn, Ti, Zr and Hf; the site of Al may be filled with one or more elements selected from the group consisting of trivalent elements such as B, Ga, In, Sc, Y, La, Gd and Lu; and the site of O or N may be filled with one or more elements selected from the group consisting of O, N and C. Further, Al and Si may be substituted with each other and at the same time O and N may be substituted with each other. Examples of that substance include Sr₃Al₂Si₁₄ON₂₂, Sr₃AlSi₁₅N₂₃, Sr₃Al₄Si₁₂O₃N₂₀, Sr₃Al₃Si₁₁O₄N₁₉ and Sr₃Al₆Si₁₀O₅N₁₈. These substances have crystal structures belonging to the same group as the Sr₃Al₃Si₁₃O₂N₂₁-type crystal.

In the case where the element replacement is occurred slightly, it can be judged by the following simple method whether or not the substance has a crystal structure belonging to the same group as the Sr₃Al₃Si₁₃O₂N₂₁-type crystal. The X-ray diffraction pattern of the substance is measured, and the positions of the diffraction peaks are compared with those in the X-ray diffraction pattern of Sr₃Al₃Si₁₃O₂N₂₁ As a result, if the positions of the main peaks are identical, those crystal structures can be regarded as the same.

The crystal structure preferably contains a component whose X-ray diffraction pattern measured by use of a specific X-ray of CuKα (wavelength: 1.54056 A) shows diffraction peaks simultaneously at seven or more positions, preferably nine or more positions selected from the group consisting of eleven positions: 15.2 to 15.5°, 23.7 to 23.9°, 25.7 to 25.9°, 29.3 to 29.5°, 30.9 to 31.1°, 31.6 to 31.8°, 31.9 to 32.1°, 34.1 to 34.3°, 34.8 to 35.0°, 36.9 to 36.5° and 37.4 to 37.6°, in terms of diffraction angle (2θ). The X-ray diffraction pattern can be measured by means of, for example, M18XHF22-SRA type X-ray diffractometer ([trademark], manufactured by MAC Science Co. Ltd.). The measurement conditions are, for example, tube voltage: 40 kV, tube current: 100 mA, and scanning speed: 2°/minute.

The green light-emitting fluorescent substance according to the embodiment is also characterized by giving an X-ray diffraction pattern in which a diffraction peak positioned at 2θ of 15.2 to 15.5° has a half-width of not more than 0.14°. That diffraction peak in patterns of conventional similar fluorescent substances has a half-width of 0.16° or more, and any fluorescent substance showing as narrow a half-width as the substance of the present embodiment has been hitherto unknown. This means the substance of the embodiment has particularly high crystallinity. Further, the fluorescent substance of the embodiment is generally in the form of tabular crystals.

The green light-emitting fluorescent substance of the present embodiment gives an X-ray diffraction pattern in which a diffraction peak positioned at 2θ of 15.2 to 15.5° has a half-width of not more than 0.14°, preferably not more than 0.13°. Here, the half-width is determined according to θ/2θ method by means of a thin film X-ray diffractometer (ATX-G [trademark], manufactured by Rigaku Corporation). The conditions for determination are as follows.
X-ray source: CuKα 50 kV-300 mA
configuration: 1.0 mm wx10.0 mm h-ss 0.48°-0.5 mmwx1.0 mm h-(sample)-0.5 mm wx1.0 mm h-0.5 mmw
measurement conditions: 2θ/θ: 5 to 65°, 0.01° step, scanning speed: 0.5°/minute

### Process for production of green light-emitting fluorescent substance

There is no particular restriction on the process for production of the green light-emitting fluorescent substance according to the embodiment, as long as it provides the substance having the above particular composition and giving the above particular X-ray diffraction pattern. However, any concrete process for producing such particular fluorescent substance has not been known. In view of that, as the method for producing that fluorescent substance, the following process is now found.

The fluorescent substance of the embodiment can be synthesized from starting materials, such as: nitride and carbide of Sr; nitride, oxide and carbide of Al and/or Si; and oxide, nitride and carbonate of the emission center element Eu. Examples of the usable materials include Sr₃N₂, AIN, Si₃N₄, Al₂O₃ and EuN. The material Sr₃N₂ can be replaced with Ca₃N₂, Ba₃N₂, Sr₂N, SrN or a mixture thereof. In a conventional production process, those materials are mixed and fired. However, the aimed substance cannot be obtained by, for example, simply placing all the powder materials in a container and then mixing them. In view of that, it is found that the aimed fluorescent substance can be obtained by the steps of weighing out the materials so that the aimed composition can be obtained, mixing them in increasing order of the added amount, and firing the prepared powder mixture in a crucible. For example, in the case where four starting materials are used, they are individually weighed out and then the material in the smallest amount is mixed with that in the second smallest amount. Subsequently, the obtained mixture is mixed with the material in the third smallest amount, and finally the prepared mixture is mixed with the material in the largest amount. It is unclear why the X-ray diffraction spectrum of the resultant fluorescent substance, namely, the crystal structure thereof is changed by mixing the materials in increasing order of the added amount, but the reason is presumed to be because the materials are more uniformly mixed.

The materials are mixed, for example, in a mortar in a glove box. The crucible is made of, for example, boron nitride, silicon nitride, silicon carbide, carbon, aluminum nitride, SiAlON, aluminum oxide, molybdenum or tungsten.

The green light-emitting fluorescent substance of the embodiment can be obtained by firing the mixture of the starting materials for a predetermined time. Particularly in the process for producing the green fluorescent substance of the embodiment, the firing time is preferably long. Specifically, the firing time is generally not less than 2 hours, preferably not less than 4 hours, more preferably not less than 6 hours, and most preferably not less than 8 hours. This is because, if the firing time is too short, the crystals often grow so insufficiently that the quantum efficiency may be lowered. The firing may be carried out either once for all or twice or more successively. If the firing is carried out twice or more successively, the intermediate product is preferably ground in the interval between the firing procedures.

The firing is preferably carried out under a pressure more than the atmospheric pressure. The pressure is preferably not less than 5 atmospheres so as to prevent the silicon nitride from decomposing at a high temperature. The firing temperature is preferably in the range of 1500 to 2000°C, more preferably in the range of 1600 to 1900°C. If the temperature is less than 1500°C, it is often difficult to obtain the aimed fluorescent substance. On the other hand, if the temperature is more than 2000°C, there is a fear that the materials or the product may be sublimated. Further, the firing is preferably carried out under N₂ atmosphere because AIN is liable to be oxidized. In that case, N₂/H₂ mixed gas atmosphere is also usable.

The fired product in the form of powder is then subjected to after-treatment such as washing, if necessary, to obtain a fluorescent substance of the embodiment. If performed, washing can be carried out with acid or pure water.

### Red light-emitting fluorescent substance

A red light-emitting fluorescent substance (R) usable in the light-emitting device of the embodiment is, for example, represented by the following formula (2):

(Sr₁₋ₓ^{,}Euₓ^{,})aSi_{b}AlO_{c}N_{d} (2)

in which x', a, b, c and d are numbers satisfying the conditions of 0<x'<0.4 (preferably, 0.02≤x'≤0.2), 0.55<a<0.80 (preferably, 0.66≤a≤0.69), 2<b<3 (preferably, 2.2≤b≤2.4), O<c≤0.6 (preferably, 0.43≤c≤0.51) and 4<d<5 (preferably, 4.2≤d≤4.3), respectively.

One of the red light-emitting fluorescent substances (R) usable in the light-emitting device of the embodiment is based on an inorganic compound having essentially the same crystal structure as Sr₂Si₇Al₃ON₁₃. However, the constituting element thereof is partly replaced with the luminance element and the content of each element is regulated in a particular range, and thereby it can be made possible for the substance to show high quantum efficiency.

The above red light-emitting fluorescent substance can be identified by X-ray diffraction or neutron diffraction. This means that the red light-emitting fluorescent substance includes not only a substance exhibiting the same X-ray diffraction pattern as Sr₂Si₇Al₃ON₁₃ but also a substance having a crystal structure in which the constituting elements are so replaced with other elements as to change the lattice constants within particular ranges. The constituting elements of Sr₂Si₇Al₃ON₁₃ crystal may be replaced with other elements in such a way described below in detail. Specifically, Sr in the crystal may be replaced with the emission center element Eu; the site of Si may be filled with one or more elements selected from the group consisting of tetravalent elements such as Ge, Sn, Ti, Zr and Hf; the site of Al may be filled with one or more elements selected from the group consisting of trivalent elements such as B, Ga, In, Sc, Y, La, Gd and Lu; and the site of O or N may be filled with one or more elements selected from the group consisting of O, N and C. Further, Al and Si may be substituted with each other and at the same time O and N may be substituted with each other. Examples of that substance include Sr₃Al₂Si₁₄ON₂₂, Sr₃AlSi₁₅N₂₃, Sr₃Al₄Si₁₂O₃N₂₀, Sr₃Al₅Si₁₁O₄N₁₉ and Sr₃Al₆Si₁₀O₅N₁₈. These substances have crystal structures belonging to the same group as the Sr₂Si₇Al₃ON₁₃-type crystal.

In the case where the replacement of element is occurred slightly, it can be judged whether or not the substance has a crystal structure belonging to the same group as the Sr₂Si₇Al₃ON₁₃-type crystal by the same simple method as described above for the green light-emitting fluorescent substance.

### Process for production of red light-emitting fluorescent substance

The red light-emitting fluorescent substance usable in the embodiment can be synthesized from starting materials, such as: nitride, carbide and cyanamide of Sr; nitride, oxide and carbide of Al and/or Si; and oxide, nitride and carbonate of the emission center element Eu. Examples of the usable materials include Sr₃N₂, AIN, Si₃N₄, Al₂O₃ and EuN. The material Sr₃N₂ can be replaced with Ca₃N₂, Ba₃N₂, Sr₂N, SrN or a mixture thereof. Those materials are weighed out and mixed so that the aimed composition can be obtained, and then the powder mixture is fired in a crucible to produce the aimed fluorescent substance. The materials are mixed, for example, in a mortar in a glove box. The crucible is made of, for example, boron nitride, silicon nitride, silicon carbide, carbon, aluminum nitride, SiAlON, aluminum oxide, molybdenum or tungsten.

The red fluorescent substance usable in the embodiment can be obtained by firing the mixture of the starting materials for a predetermined time. The firing time is generally not more than 4 hours, preferably 3 hours or less, more preferably 2 hours or less, most preferably 1 hour or less. This is because, if the firing time is too long, the crystals aggregate to increase the grain size and consequently to lower the quantum efficiency. Further, if the firing time is too long, the resultant product is liable to contain a decreased amount of the crystals having a particular aspect ratio. However, from the viewpoint of making the reaction fully proceed, the firing time is preferably not less than 0.1 hour, more preferably not less than 0.1 hour, most preferably not less than 0.5 hour. The firing may be carried out either once for all or twice or more successively.

The firing is preferably carried out under a pressure more than the atmospheric pressure. The pressure is preferably not less than 5 atmospheres so as to prevent the silicon nitride from decomposing at a high temperature. The firing temperature is preferably in the range of 1500 to 2000°C, more preferably in the range of 1600 to 1900°C. If the temperature is less than 1500°C, it is often difficult to obtain the aimed fluorescent substance. On the other hand, if the temperature is more than 2000°C, there is a fear that the materials or the product may be sublimated. Further, the firing is preferably carried out under N₂ atmosphere because AIN is liable to be oxidized. In that case, N₂/H₂ mixed gas atmosphere is also usable.

The fired product in the form of powder is then subjected to after-treatment such as washing, if necessary, to obtain a fluorescent substance according to the embodiment. If performed, washing can be carried out with acid or pure water.

### Blue light-emitting fluorescent substance

As described later, the light-emitting device of the embodiment comprises the aforementioned red and green light-emitting fluorescent substances in combination. In addition, the device may further comprise a blue light-emitting fluorescent substance. There is no particular restriction on the blue light-emitting fluorescent substance as long as it emits luminescence having a peak in the wavelength range of 400 to 490 nm.

However, if the blue light-emitting fluorescent substance has poor temperature characteristics, the resultant light radiated from the device may have chromaticity shifted toward the yellow side when the temperature rises in accordance with increase of the applied power. This may be a problem particularly if white light is required. Accordingly, for the purpose of achieving the object of the present embodiment, namely, in order to provide a light-emitting device less undergoing color discrepancies, it is preferred for the blue light-emitting fluorescent substance to have temperature characteristics as excellent as the red and green light-emitting ones.

Examples of the preferred blue light-emitting fluorescent substance include (Ba,Eu)MgAl₁₀O₁₇, (Sr,Ca,Ba,Eu),₁₀(PO₄)₅Cl₂ and (Sr,Eu)Si₉Al₁₉ON₃₁.

### Light-emitting device

A light-emitting device according to the embodiment comprises the above fluorescent substances and a light-emitting element capable of exciting those fluorescent substances.

The device according to one aspect of the embodiment comprises: a LED serving as an excitation source; and a combination of the aforementioned red light-emitting fluorescent substance (R) and the aforementioned green light-emitting fluorescent substance (G) each of which emits luminescence under excitation by light given off from the LED. Accordingly, the light-emitting device radiates light synthesized with emissions from the LED and the red and green fluorescent substances.

The light-emitting device according to another aspect of the embodiment comprises: a LED serving as an excitation source; and a combination of the above red light-emitting fluorescent substance (R), the above green light-emitting fluorescent substance (G), and the blue light-emitting fluorescent substance (B) each of which emits luminescence under excitation by light given off from the LED.

The device according to either aspect of the embodiment indispensably comprises the particular red light-emitting fluorescent substance (R) and the particular green light-emitting fluorescent substance (G) in combination, and thereby the color balance between red and green in the light radiated from the device is prevented from being lost while the device is working, so that the color discrepancies are prevented. Further, since less undergoing the temperature quenching in operation, those particular fluorescent substances hardly lose the luminance balances with the emission from the LED and with the blue luminescence from the blue light-emitting fluorescent substance. This also contributes to prevention of the color discrepancies.

In the present embodiment, both the red and green light-emitting fluorescent substances less undergo the temperature quenching. They therefore enable to realize a light-emitting device radiating light in which red and green light components less fluctuate even when the device is operated with high power. Further, since the temperature quenching acts on those two substances to a similar degree at temperatures from room temperature to approx. 200°C, they also enable to realize a light-emitting device radiating light less suffering from color discrepancies of red and green light components even when the device temperature is increased by operation with high power. Although it is possible to produce a light-emitting device even if red and green light-emitting fluorescent substances used therein are different from the substances regulated in the present embodiment, such device is generally incapable of benefitting fully from the effect of preventing color discrepancies, as compared with the device of the embodiment.

The blue light-emitting fluorescent substance, if used, preferably undergoes the temperature quenching to the same degree as the red and green light-emitting ones because color discrepancies can be further effectively prevented. However, since the luminescence from the blue light-emitting fluorescent substance can be compensated with the emission from a LED serving as the excitation light-emitting element, the blue light-emitting fluorescent substance does not need to be regulated so strictly as the red and green light-emitting ones.

The light-emitting element used in the device is properly selected according to the fluorescent substances used together. Specifically, it is necessary that light given off from the light-emitting element be capable of exciting the fluorescent substances. Further, if the device is preferred to radiate white light, the light-emitting element preferably gives off light of such a wavelength that it can complement luminescence emitted from the fluorescent substances.

In view of the above, if the device comprises the red and green fluorescent substances, the light-emitting element (S1) is generally so selected that it gives off light in the wavelength range of 250 to 500 nm. If the device comprises the red, green and blue fluorescent substances, the light-emitting element (S2) is generally so selected that it gives off light of 250 to 430 nm.

The light-emitting device according to the embodiment can be in the form of any conventionally known light-emitting device. Figure 2 is a vertical sectional view schematically illustrating a light-emitting device of the embodiment.

In the light-emitting device shown in Figure 2, a resin system 100 comprises leads 101 and 102 molded as parts of a lead frame and also a resin member 103 formed by unified molding together with the lead frame. The resin member 103 gives a concavity 105 in which the top opening is larger than the bottom. On the inside wall of the concavity, a reflective surface 104 is provided.

At the center of the nearly circular bottom of the concavity 105, a light-emitting element 106 is mounted with Ag paste. Examples of the light-emitting element 106 include a light-emitting diode and a laser diode. The light-emitting element may radiate UV light. There is no particular restriction on the light-emitting element. Accordingly, it is also possible to adopt an element capable of emitting blue, bluish violet or near UV light as well as UV light. For example, a semiconductor light-emitting element such as a GaN-type one can be used as the light-emitting element. The electrodes (not shown) of the light-emitting element 106 are connected to the leads 101 and 102 by way of bonding wires 107 and 108 made of Au, respectively. The positions of the leads 101 and 102 can be adequately modified.

In the concavity 105 of the resin member 103, a phosphor layer 109 is provided. For forming the phosphor layer 109, a mixture 110 containing the fluorescent substance of the embodiment can be dispersed or precipitated in an amount of 5 to 50 wt% in a resin layer 111 made of silicone resin. The fluorescent substance of the embodiment comprises an oxynitride matrix having high covalency, and hence is generally so hydrophobic that it has good compatibility with the resin. Accordingly, scattering at the interface between the resin and the fluorescent substance is prevented enough to improve the light-extraction efficiency.

The light-emitting element 106 may be of a flip chip type in which n-type and p-type electrodes are placed on the same plane. This element can avoid troubles concerning the wires, such as disconnection or dislocation of the wires and light-absorption by the wires. In that case, therefore, it is possible to obtain a semiconductor light-emitting device excellent both in reliability and in luminance. Further, it is also possible to employ an n-type substrate in the light-emitting element 106 so as to produce a light-emitting device constituted as described below. In that device, an n-type electrode is formed on the back surface of the n-type substrate while a p-type electrode is formed on the top surface of the semiconductor layer on the substrate. One of the n-type and p-type electrodes is mounted on one of the leads, and the other electrode is connected to the other lead by way of a wire. The size of the light-emitting element 106 and the dimension and shape of the concavity 105 can be properly changed.

The light-emitting device according to the embodiment is not restricted to the package cup-type shown in Figure 2, and can be freely applied to any type of devices. For example, even if the fluorescent substance according to the embodiment is used in a shell-type or surface-mount type light-emitting device, the same effect can be obtained.

### EXAMPLES

The embodiment is further explained by the following examples, which by no means restrict the embodiment.

### Example 1

As the starting materials, Sr₃N₂, EuN, Si₃Nₐ, Al₂O₃ and AIN in the amounts of 2.579 g, 0.232 g, 4.583 g, 0.476 g and 1.339 g, respectively, were weighed out in a vacuum glove box and dry-mixed in an agate mortar. The mixture was placed in a BN crucible and then fired at 1850°C for 4 hours under 7.5 atm of N₂ atmosphere, to synthesize a fluorescent substance (R1) whose designed composition was (Sr_{0.95}Eu_{0.05})₂Al₃Si₇ON₁₃.

The substance (R1) after firing was in the form of orange powder, and emitted red luminescence when excited with black light.

Independently, Sr₃N₂, EuN, Si₃N₄, Al₂O₃ and AIN as the starting materials in the amounts of 2.676 g, 0.398 g, 6.080 g, 0.680 g and 0.683 g, respectively, were weighed out in a vacuum glove box and then dry-mixed in increasing order of the added amount in an agate mortar. The mixture was placed in a BN crucible and then fired at 1850°C for 4 hours under 7.5 atm of N₂ atmosphere, to synthesize a fluorescent substance (G1) whose designed composition was (Sr_{0.92}Eu_{0.08})₃Al₃Si₁₃O₂N₂₁.

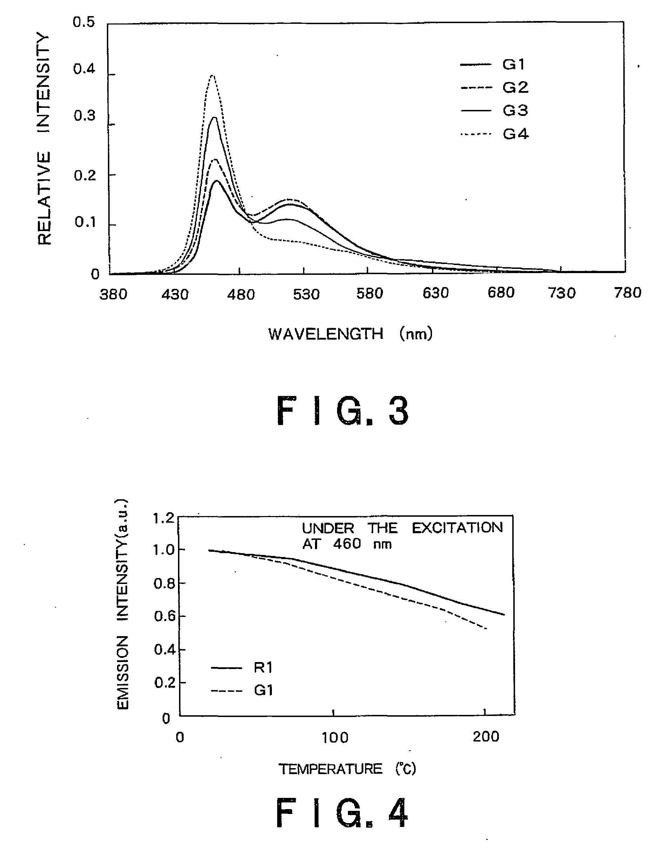

The substance (G1) after firing was in the form of yellowish green powder, and emitted green luminescence when excited with black light. Figure 3 shows an emission spectrum of the green light-emitting fluorescent substance (G1) under excitation by light at 457 nm. The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.139°. Further, the luminous efficiency of the substance was found to be 56%. The luminous efficiency was measured by means of an absolute PL quantum yield measurement system (C9920-02G [trademark], manufactured by Hamamatsu Photonics K.K.) and calculated provided that the efficiency was regarded as 100% if all the photons applied to the substance were completely absorbed and converted into luminescence emitted at a wavelength different from the incident wavelength.

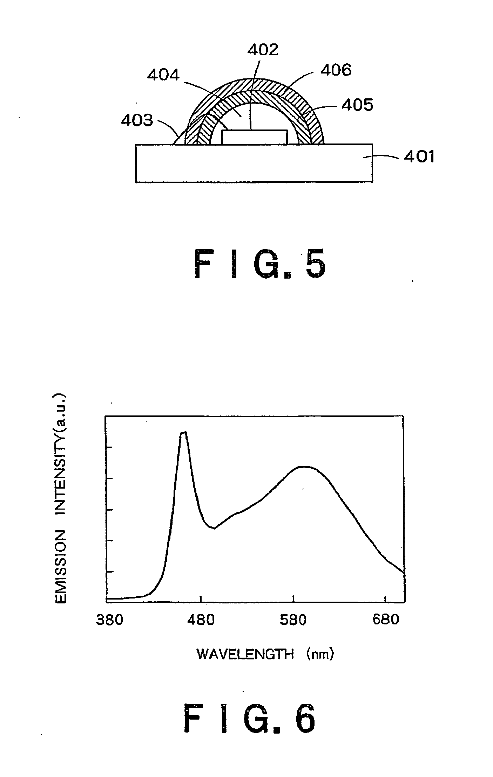

A light-emitting device was produced by use of those fluorescent substances. Figure 4 shows graphs giving temperature dependence of luminescence emitted from the green light-emitting fluorescent substance (G1) and the red one (R1). The graphs were so normalized that the emission intensity was regarded as 1.0 at room temperature. The device had a structure according to Figure 5. Specifically, a LED 402 emitting light having a peak at 455 nm was soldered on an 8 mm-square AIN package substrate 401, and was connected to electrodes by way of gold wires 403. The LED was then domed with transparent resin 404, and the dome was coated with a layer of transparent resin 405 containing 30 wt% of the red light-emitting fluorescent substance (R1) capable of giving off luminescence having a peak at 598 nm. Further, another layer of transparent resin 406 containing 30 wt% of the fluorescent substance (G1) was formed thereon, to produce a light-emitting device. The produced device was placed in an integrating sphere, and was then worked with 20 mA and 3.1 V. The radiated light was observed and found to have a chromaticity of (0.345, 0.352), a color temperature of 5000K, a luminous flux efficiency of 67.9 Im/W and Ra=86. Figure 6 shows an emission spectrum of the produced device.

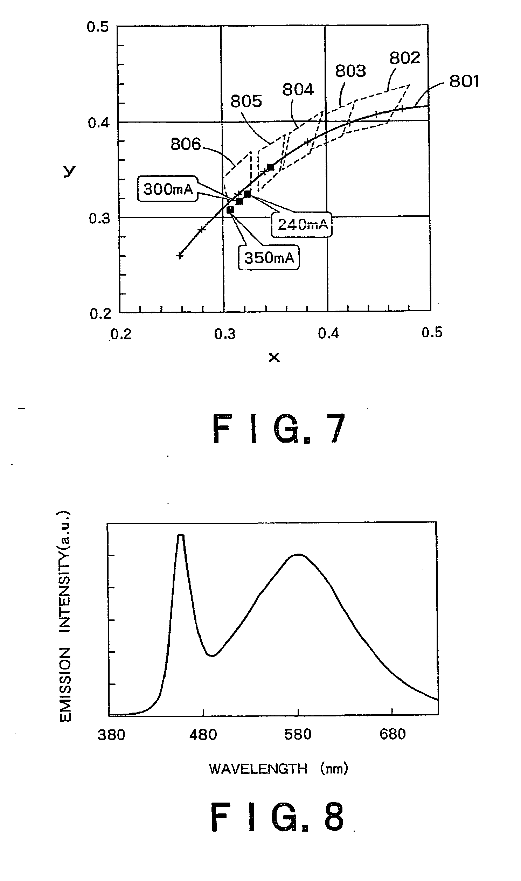

While the drive current was being increased to 350 mA, the luminance characteristics of the device were measured in the manner described above. As a result shown in Figure 7, the chromaticity fluctuated in such a small range even when the drive current was increased, as not to deviate from the chromaticity range regulated by JIS (Japanese Industrial Standards) even when the device was operated with 350 mA. The luminous flux efficiency and Ra also fluctuated in such small ranges as to be 52.0 Im/W and Ra=79, respectively, at 240 mA; 48.3 Im/W and Ra=77, respectively, at 300 mA; and 43.9 Im/W and Ra=75, respectively, at 350 mA. In Figure 7, areas 801 to 805 correspond to the chromaticity ranges of daylight, natural white, white, warm white and incandescent color, respectively, regulated by JIS while an area 806 corresponds to the Planckian locus.

### Example 2

The red light-emitting fluorescent substance (R1) was synthesized in the same manner as in Example 1. The procedure of Example 1 was then repeated except that the firing time was changed into 6 hours, to synthesize a green light-emitting fluorescent substance (G2). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.137°. Further, the luminous efficiency of the substance was found to be 62%.

A light-emitting device was produced by use of those fluorescent substances in the same manner as in Example 1. The produced device was placed in an integrating sphere, and was then worked with 20 mA and 3.1 V. The radiated light was observed and found to have a chromaticity of (0.345, 0.352), a color temperature of 5000K, a luminous flux efficiency of 73.8 lm/W and Ra=79. Figure 8 shows an emission spectrum of the produced device.

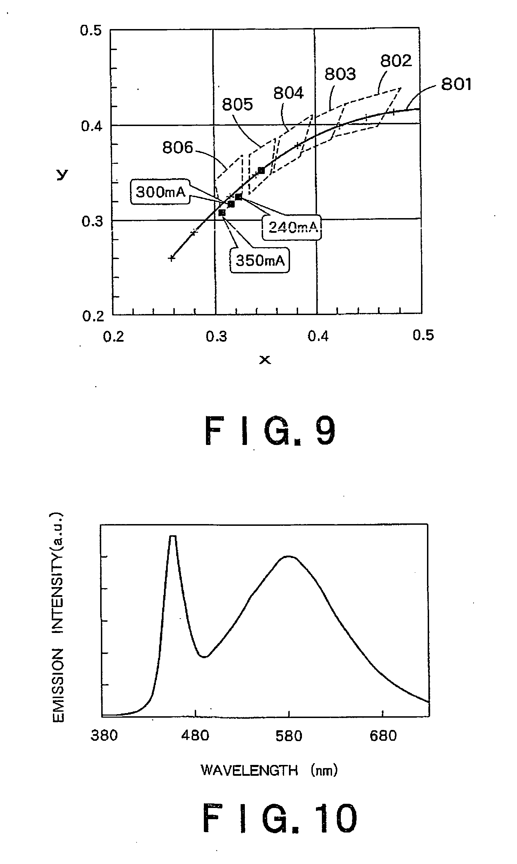

While the drive current was being increased to 350 mA, the luminance characteristics of the device were measured in the manner described above. As a result shown in Figure 9, the chromaticity fluctuated in a small range even when the drive current was increased. The luminous flux efficiency and Ra also fluctuated in such small ranges as to be 56.8 lm/W and Ra=78, respectively, at 240 mA; 53.5 lm/W and Ra=77, respectively, at 300 mA; and 49.1 lm/W and Ra=76, respectively, at 350 mA.

### Example 3

The red light-emitting fluorescent substance (R1) was synthesized in the same manner as in Example 1. The procedure of Example 1 was then repeated except that the firing time was changed into 8.0 hours, to synthesize a green light-emitting fluorescent substance (G3). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.134°. Further, the luminous efficiency of the substance was found to be 64%.

A light-emitting device was produced by use of those fluorescent substances in the same manner as in Example 1. The produced device was placed in an integrating sphere, and was then worked with 20 mA and 3.1 V. The radiated light was observed and found to have a chromaticity of (0.345, 0.352), a color temperature of 5000K, a luminous flux efficiency of 64.8 lm/W and Ra=90. Figure 10 shows an emission spectrum of the produced device working at 20 mA drive current.

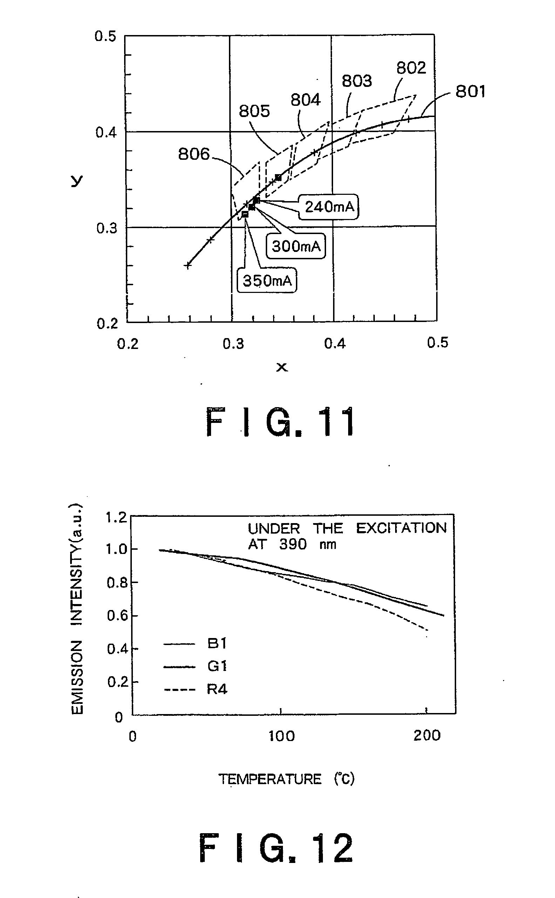

While the drive current was being increased to 350 mA, the luminance characteristics of the device were measured in the manner described above. As a result shown in Figure 11, the chromaticity fluctuated in such a small range even when the drive current was increased, as not to deviate from the chromaticity range regulated by JIS (Japanese Industrial Standards) even when the device was operated with 350 mA. The luminous flux efficiency and Ra also fluctuated in such small ranges as to be 51.0 Im/W and Ra=85, respectively, at 240 mA; 48.0 lm/W and Ra=84, respectively, at 300 mA; and 44.3 lm/W and Ra=82, respectively, at 350 mA.

### Example 4

The red light-emitting fluorescent substance (R1) was synthesized in the same manner as in Example 1. The procedure of Example 1 was then repeated except that only the firing atmosphere was changed into H₂:N₂=5:5 atmosphere, to synthesize a green light-emitting fluorescent substance (G4). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.129°. Further, the luminous efficiency of the substance was found to be 62%.

A light-emitting device was produced by use of those fluorescent substances. Specifically, a LED emitting light having a peak at 390 nm was soldered on an 8 mm-square AIN package substrate, and was connected to electrodes by way of gold wires. The LED was then domed with transparent resin, and the dome was coated with a layer of transparent resin containing 30 wt% of the red light-emitting fluorescent substance (R1) capable of giving off luminescence having a peak at 598 nm. Further, another layer of transparent resin containing 30 wt% of the fluorescent substance (G4) and still another layer of transparent resin containing 30 wt% of a blue light-emitting fluorescent substance (Ba_{0.9}Eu_{0.1})MgAl₁₀O₁₇ (B1) were stacked thereon, to produce a light-emitting device. Figure 12 shows temperature dependence of the emission intensity given by each of the green, red and blue light-emitting fluorescent substances (G4), (R1) and (B1), provided that the intensity at room temperature is regarded as 1.0.

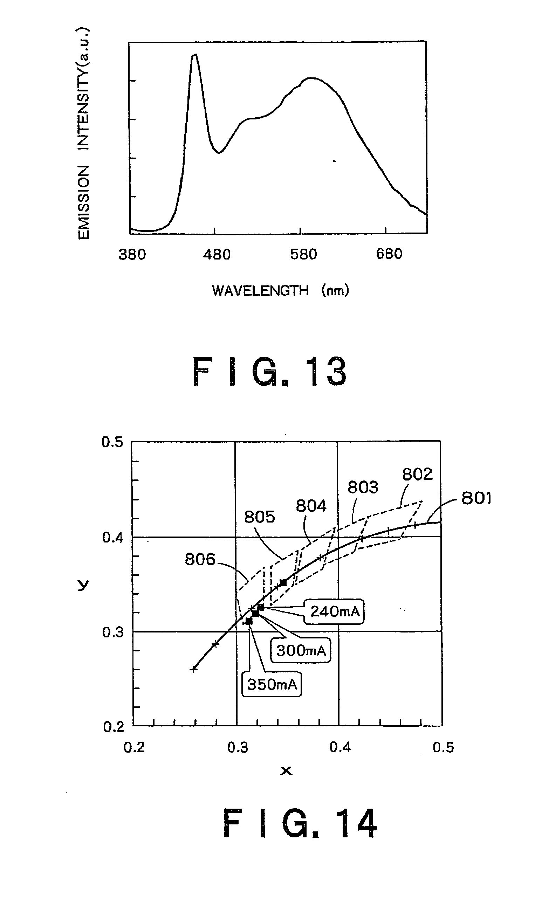

The produced device was placed in an integrating sphere, and was then worked with 20 mA and 3.1 V. The radiated light was observed and found to have a chromaticity of (0.345, 0.352), a color temperature of 5000K, a luminous flux efficiency of 62.39 lm/W and Ra=90. Figure 13 shows an emission spectrum of the produced device.

While the drive current was being increased to 350 mA, the luminance characteristics of the device were measured in the manner described above. As a result shown in Figure 14, the chromaticity fluctuated in such a small range even when the drive current was increased, as not to deviate from the chromaticity range of natural white regulated by JIS (Japanese Industrial Standards) even when the device was operated with 350 mA. The luminous flux efficiency, Ra and chromaticity also fluctuated in such small ranges as to be 47.7 lm/w, Ra=89 and (x, y)=(0.341, 0.348), respectively, at 240 mA; 44.7 lm/W, Ra=88 and (x, y)=(0.339, 0.349), respectively, at 300 mA; and 41.5 lm/W, Ra=88 and (x, y)=(0.336, 0.347), respectively, at 350 mA.

### Example 5

The red light-emitting fluorescent substance (R1) was synthesized in the same manner as in Example 1. The procedure of Example 2 was then repeated except that only the firing atmosphere was changed into H₂:N₂=5:5 atmosphere, to synthesize a green light-emitting fluorescent substance (G5). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.119°. Further, the luminous efficiency of the substance was found to be 60%.

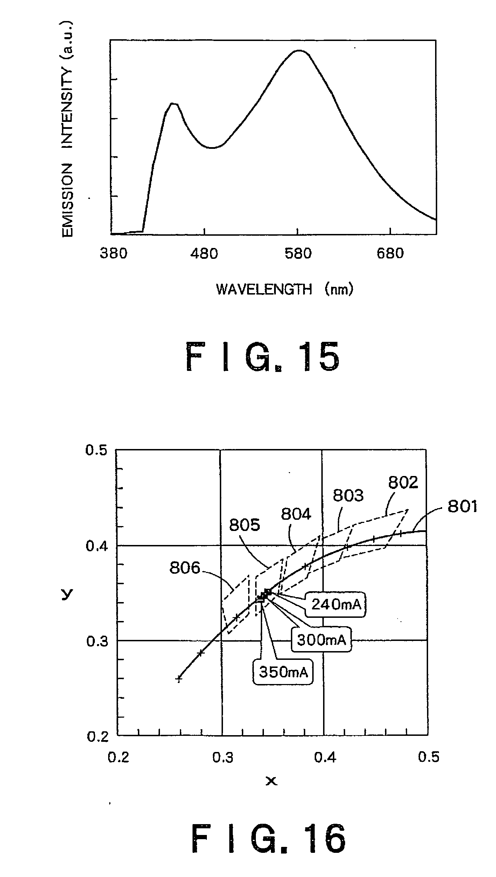

A light-emitting device was produced by use of those fluorescent substances in the same manner as in Example 4. The produced device was placed in an integrating sphere, and was then worked with 20 mA and 3.1 V. The radiated light was observed and found to have a chromaticity of (0.345, 0.352), a color temperature of 5000K, a luminous flux efficiency of 70.49 lm/W and Ra=81. Figure 15 shows an emission spectrum of the produced device.

While the drive current was being increased to 350 mA, the luminance characteristics of the device were measured in the manner described above. As a result shown in Figure 16, the chromaticity fluctuated in such a small range even when the drive current was increased, as not to deviate from the chromaticity range of natural white regulated by JIS (Japanese Industrial Standards) even when the device was operated with 350 mA. The luminous flux efficiency, Ra and chromaticity also fluctuated in such small ranges as to be 53.5 Im/W, Ra=81 and (x, y)=(0.341, 0.348), respectively, at 240 mA; 50.2 Im/W, Ra=81 and (x, y)=(0.340, 0.346), respectively, at 300 mA; and 46.1 Im/W, Ra=81 and (x, y)=(0.337, 0.343), respectively, at 350 mA.

### Example 6

The red light-emitting fluorescent substance (R1) was synthesized in the same manner as in Example 1. The procedure of Example 3 was then repeated except that only the firing atmosphere was changed into H₂:N₂=5:5 atmosphere, to synthesize a green light-emitting fluorescent substance (G6). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0,117°. Further, the luminous efficiency of the substance was found to be 55%.

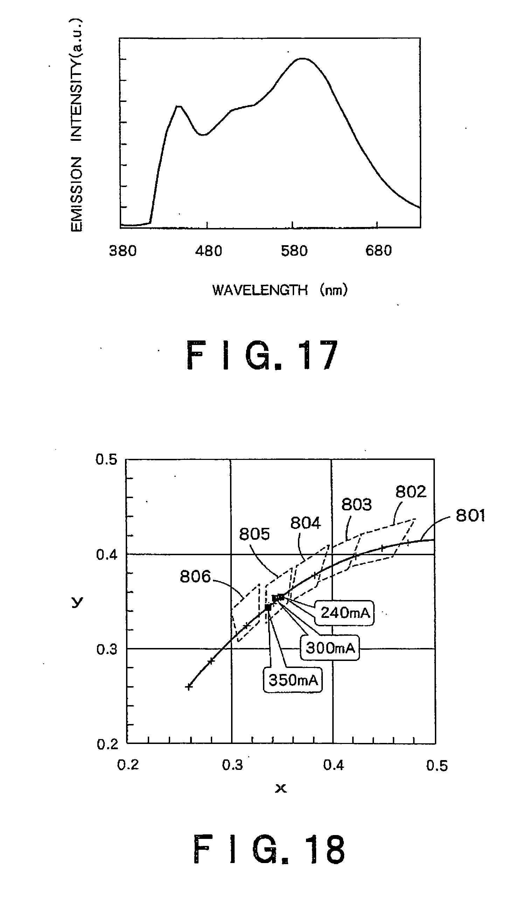

A light-emitting device was produced by use of those fluorescent substances in the same manner as in Example 4. The produced device was placed in an integrating sphere, and was then worked with 20 mA and 3.1 V. The radiated light was observed and found to have a chromaticity of (0.345, 0.352), a color temperature of 5000K, a luminous flux efficiency of 59.79 Im/W and Ra=92. Figure 17 shows an emission spectrum of the produced device.

While the drive current was being increased to 350 mA, the luminance characteristics of the device were measured in the manner described above. As a result shown in Figure 18, the chromaticity fluctuated in such a small range even when the drive current was increased, as not to deviate from the chromaticity range of natural white regulated by JIS (Japanese Industrial Standards) even when the device was operated with 350 mA. The luminous flux efficiency, Ra and chromaticity also fluctuated in such small ranges as to be 46.5 Im/W, Ra=91 and (x, y)=(0.34, 0.351), respectively, at 240 mA; 43.5 Im/W, Ra=81 and (x, y)=(0.339, 0.35), respectively, at 300 mA; and 39.9 Im/W, Ra=90 and (x, y)=(0.336, 0.348), respectively, at 350 mA.

### Example 7

As the starting materials, SrCO₃, Eu₂O₃, Si₃N₄ and AIN in the amounts of 0.664 g, 0.792 g, 3.788 g and 7.009 g, respectively, were weighed out and dry-mixed in an agate mortar in a vacuum glove box. The mixture was placed in a BN crucible and then fired at 1800°C for 4 hours under 7.5 atm of N₂ atmosphere, to synthesize a fluorescent substance (B2) whose designed composition was (Sr_{0.50}Eu_{0.50})₃ Si₉Al₁₉ON₃₁

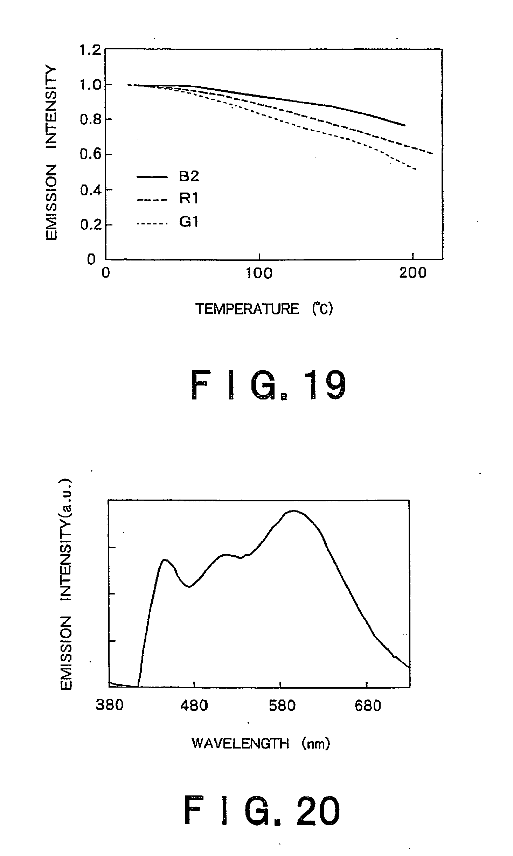

The procedure of Example 1 was then repeated to synthesize green and red light-emitting fluorescent substances (G1) and (R1). Figure 19 shows temperature dependence of the emission intensity given by each of the green, red and blue light-emitting fluorescent substances (G1), (R1) and (B2), provided that the intensity at room temperature is regarded as 1.0.

A light-emitting device was produced by use of those fluorescent substances in the same manner as in Example 4. The produced device was placed in an integrating sphere, and was then worked with 20 mA and 3.1 V. The radiated light was observed and found to have a chromaticity of (0.345, 0.352), a color temperature of 5000K, a luminous flux efficiency of 56.09 Im/W and Ra=89. Figure 20 shows an emission spectrum of the produced device.

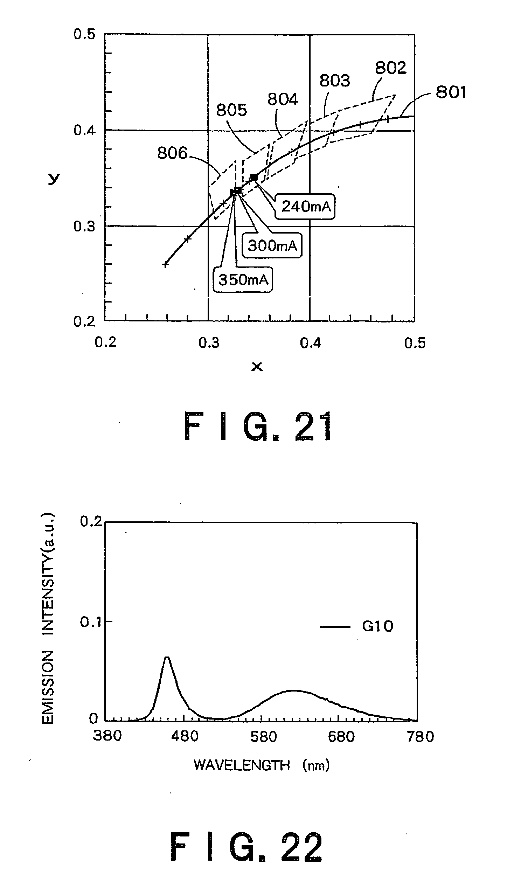

While the drive current was being increased to 350 mA, the luminance characteristics of the device were measured in the manner described above. As a result shown in Figure 21, the chromaticity fluctuated in such a small range even when the drive current was increased, as not to deviate from the chromaticity range of natural white regulated by JIS (Japanese Industrial Standards) even when the device was operated with 350 mA. The luminous flux efficiency, Ra and chromaticity also fluctuated in such small ranges as to be 43.9 Im/W, Ra=85 and (x, y)=(0.331, 0.340), respectively, at 240 mA; 43.9 Im/W, Ra=85 and (x, y)=(0.329, 0.339), respectively, at 300 mA; and 38.0 Im/W, Ra=84 and (x, y)=(0.327, 0.337), respectively, at 350 mA.

### Example 8

The red light-emitting fluorescent substance (R1) was synthesized in the same manner as in Example 1. Sr₃N₂, EuN, Si₃N₄, Al₂O₃ and AIN as the starting materials were weighed out in a vacuum glove box. The procedure for producing G1 was repeated except that Sr₃N₂, EuN, Si₃N₄, Al₂O₃ and AIN in the amounts of 2.676 g, 0.398 g, 6.548 g, 0.340 g and 0.547 g, respectively, were weighed to synthesize a green light-emitting fluorescent substance (G7). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.124°. Further, the luminous efficiency of the substance was found to be 59%.

A light-emitting device was produced by use of those fluorescent substances in the same manner as in Example 4. The produced device was placed in an integrating sphere, and was then worked with 20 mA and 3.1 V. The radiated light was observed and found to have a chromaticity of (0.345, 0.352), a color temperature of 5000K, a luminous flux efficiency of 58.35 Im/W and Ra=88.

### Example 9

The red light-emitting fluorescent substance (R1) was synthesized in the same manner as in Example 1. The procedure for producing G1 was repeated except that Sr₃N₂, EuN, Si₃N₄, Al₂O₃ and AIN in the amounts of 2.676 g, 0.398 g, 6.431 g, 0.425 g and 0.581 g, respectively, were weighed to synthesize a green light-emitting fluorescent substance (G8). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.137°. Further, the luminous efficiency of the substance was found to be 59%.

A light-emitting device was produced by use of those fluorescent substances in the same manner as in Example 4. The produced device was placed in an integrating sphere, and was then worked with 20 mA and 3.1 V. The radiated light was observed and found to have a chromaticity of (0.345, 0.352), a color temperature of 5000K, a luminous flux efficiency of 58.37 Im/W and Ra=90.

### Example 10

The red light-emitting fluorescent substance (R1) was synthesized in the same manner as in Example 1. The procedure for producing G1 was repeated except that Sr₃N₂, EuN, Si₃N₄, Al₂O₃ and AIN in the amounts of 2.676 g, 0.398 g, 6.314 g, 0.510 g and 0.615 g, respectively, were weighed to synthesize a green light-emitting fluorescent substance (G9). The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.126°. Further, the luminous efficiency of the substance was found to be 62%.

A light-emitting device was produced by use of those fluorescent substances in the same manner as in Example 4. The produced device was placed in an integrating sphere, and was then worked with 20 mA and 3.1 V. The radiated light was observed and found to have a chromaticity of (0.345, 0.352), a color temperature of 5000K, a luminous flux efficiency of 61.21 Im/W and Ra=92.

### Comparative Example 1

The red light-emitting fluorescent substance (R1) was synthesized in the same manner as in Example 1. The procedure of Example 1 was then repeated except that all the powder materials were weighed out, placed all together in a crucible and dry-mixed once for all, to synthesize a green light-emitting fluorescent substance (G10) for comparison.

The substance (G10) after firing was in the form of yellowish green powder, and emitted green luminescence when excited with black light. Figure 22 shows an emission spectrum of the green light-emitting fluorescent substance (G10) under excitation by light at 457 nm. The X-ray diffraction pattern of this substance was measured and found to have almost the same main peaks as that of the Sr₃Al₃Si₁₃O₂N₂₁-type crystal. The diffraction peak positioned at 2θ of 15.2 to 15.5° was also found to have a half-width of 0.164°. Further, the luminous efficiency of the substance was found to be 47%.

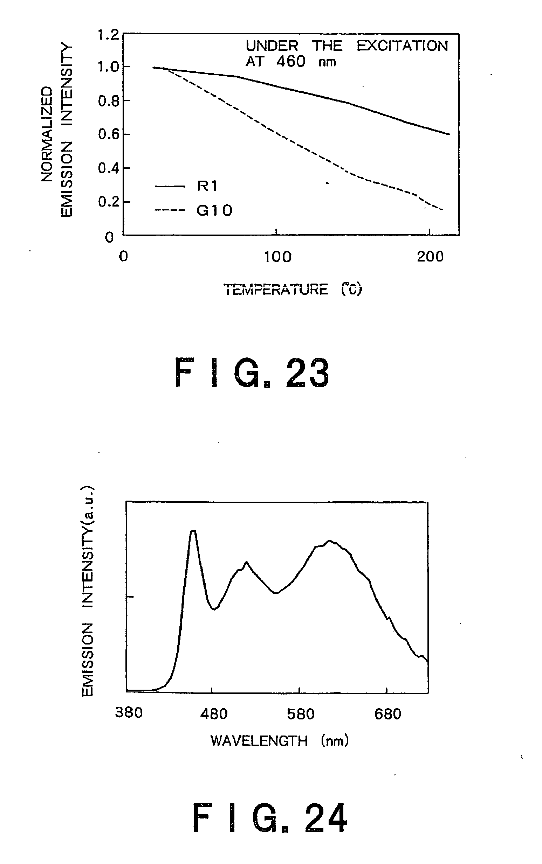

Figure 23 shows temperature dependence of the emission intensity given by each of the green and red light-emitting fluorescent substances (G10) and (R1), provided that the intensity at room temperature is regarded as 1.0.

A light-emitting device was produced by use of those fluorescent substances in the same manner as in Example 4. The produced device was placed in an integrating sphere, and was then worked with 20 mA and 3.1 V. The radiated light was observed and found to have a chromaticity of (0.345, 0.352), a color temperature of 5000K, a luminous flux efficiency of 24.0 Im/W and Ra=91. Figure 24 shows an emission spectrum of the produced device.

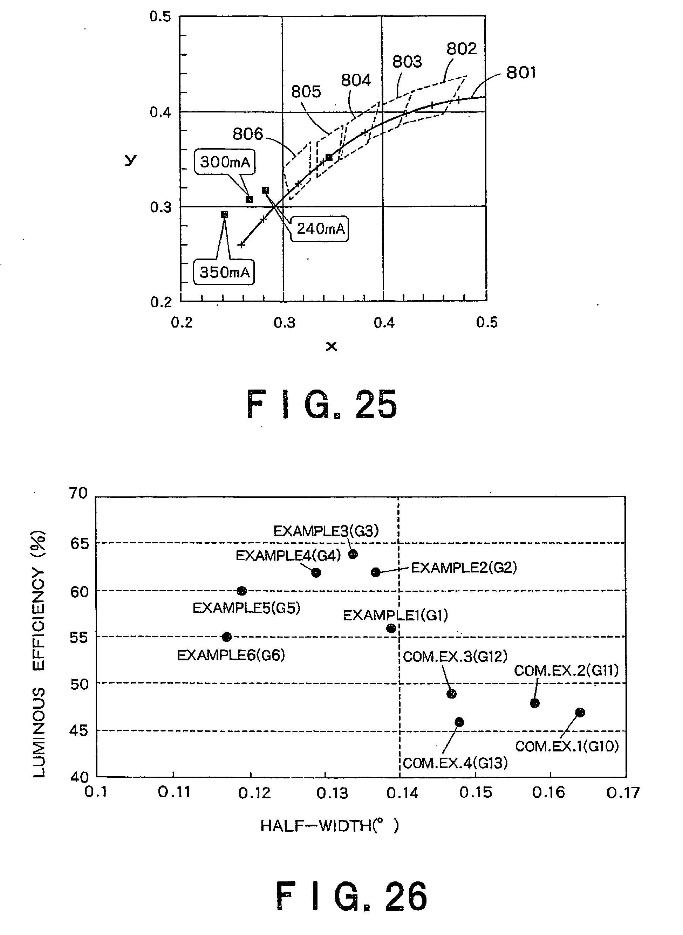

While the drive current was being increased to 350 mA, the luminance characteristics of the device were measured in the manner described above. As a result shown in Figure 25, the chromaticity fluctuated in such a large range when the drive current was increased, as to deviate considerably from the chromaticity range regulated by JIS (Japanese Industrial Standards). The luminous flux efficiency and Ra also decreased to such large degrees as to be 15.5 Im/W and Ra=72, respectively, at 240 mA; 14.0 Im/W and Ra=66, respectively, at 300 mA; and 12.2 Im/W and Ra=53, respectively, at 350 mA.

### Comparative Example 2

The procedure for synthesizing the green light-emitting fluorescent substance (G3) in Example 3 was repeated except that all the powder materials were weighed out, placed all together in a crucible and dry-mixed once for all, to synthesize a green light-emitting fluorescent substance (G11) for comparison.

The X-ray diffraction pattern of the substance (G11) after firing was measured and found to have almost the same main peaks as that of the Sr₃Al₃Si₁₃O₂N₂₁-type crystal. The diffraction peak positioned at 2θ of 15.2 to 15.5° was also found to have a half-width of 0.158°. Further, the luminous efficiency of the substance was found to be 48%.

### Comparative Example 3

The procedure for synthesizing the green light-emitting fluorescent substance (G4) in Example 4 was repeated except that all the powder materials were weighed out, placed all together in a crucible and dry-mixed once for all, to synthesize a green light-emitting fluorescent substance (G12) for comparison.

The X-ray diffraction pattern of the substance (G12) after firing was measured and found to have almost the same main peaks as that of the Sr₃Al₃Si₁₃O₂N₂₁-type crystal. The diffraction peak positioned at 2θ of 15.2 to 15.5° was also found to have a half-width of 0.147°. Further, the luminous efficiency of the substance was found to be 49%.

### Comparative Example 4

The procedure for synthesizing the green light-emitting fluorescent substance (G6) in Example 6 was repeated except that all the powder materials were weighed out, placed all together in a crucible and dry-mixed once for all, to synthesize a green light-emitting fluorescent substance (G13) for comparison.

The X-ray diffraction pattern of the substance (G13) after firing was measured and found to have almost the same main peaks as that of the Sr₃Al₃Si₁₃O₂N₂₁-type crystal. The diffraction peak positioned at 2θ of 15.2 to 15.5° was also found to have a half-width of 0.148°. Further, the luminous efficiency of the substance was found to be 46%.

### (Comparison of luminous efficiency)

Figure 26 shows a relation between the luminous efficiency and the half-width of X-ray diffraction peak with regard to the green light-emitting fluorescent substance produced in each Example and Comparative Example

### Comparative Example 5

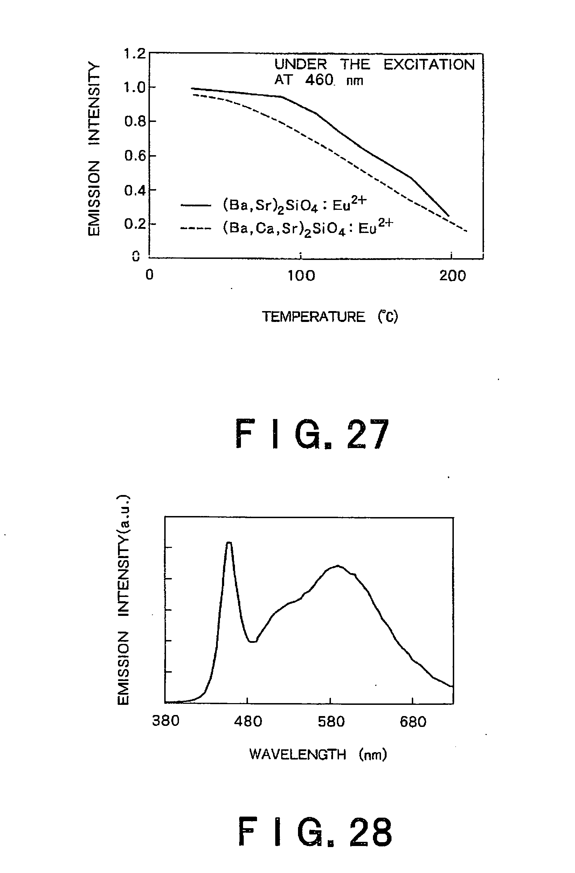

A light-emitting device was produced in the following manner. Specifically, a LED emitting light having a peak at 455 nm was soldered on an 8 mm-square AIN package substrate, and was connected to electrodes by way of gold wires. The LED was then domed with transparent resin, and the dome was coated with a layer of transparent resin containing 40 wt% of a red light-emitting fluorescent substance (Ba_{0.1}Sr_{0.8}Ca_{0.1})₂SiO₄:Eu²⁺ capable of giving off luminescence having a peak at 585 nm. Further, another layer of transparent resin containing 30 wt% of a green light-emitting fluorescent substance (Ba_{0.1}Sr_{0.8})₂SiO₄:Eu²⁺ was formed thereon, to produce a iight-emitting device having a structure according to Figure 5. Figure 27 shows temperature dependence of the emission intensity given by each of the green and red light-emitting fluorescent substances, provided that the intensity at room temperature is regarded as 1.0. The produced device was placed in an integrating sphere, and was then worked with 20 mA and 3.1 V. The radiated light was observed and found to have a chromaticity of (0.345, 0.352), a color temperature of 5000K, a luminous flux efficiency of 68.6 Im/W and Ra=86. Figure 28 shows an emission spectrum of the produced device working at 20mA drive current.

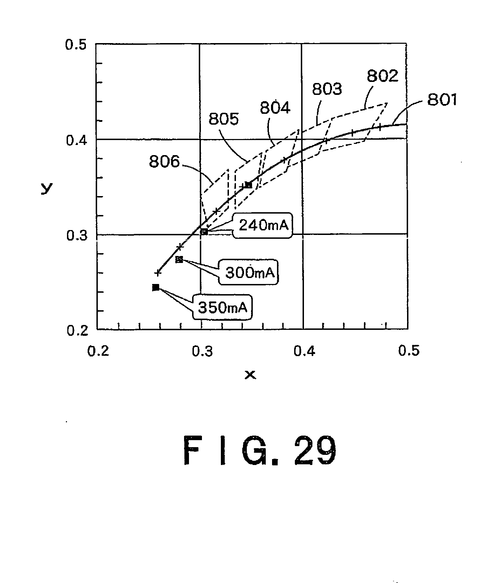

While the drive current was being increased to 350 mA, the luminance characteristics of the device were measured in the manner described above. As a result shown in Figure 29, the chromaticity fluctuated in such a large range when the drive current was increased, as to deviate considerably from the chromaticity range regulated by JIS (Japanese Industrial Standards). The luminous flux efficiency and Ra also decreased to such large degrees as to be 43.9 Im/W and Ra=76, respectively, at 240 mA; 33.9 Im/W and Ra=68, respectively, at 300 mA; and 26.9 Im/W and Ra=57, respectively, at 350 mA.

While certain embodiments have been described, these embodiments have been presented by way of example only, and are not intended to limit the scope of the inventions. Indeed, the novel methods and systems described herein may be embodied in a variety of other forms; furthermore, various omissions, substitutions and changes in the form of the methods and systems described herein may be made without departing from the scope of the invention as defined by the appended claims.

## Claims

1. A fluorescent substance
represented by the following formula (1):
(Sr₁₋ₓEuₓ)_{3-y}Al_{3+z}Si_{13-z}O₂₊ᵤN_{21-w} (1)
in which x, y, z, u and w are numbers satisfying the conditions of 0<x<1, - 0.1≤y≤0.3, -3≤z≤1 and -3<u-w≤1.5, respectively;
giving an X-ray diffraction pattern in which a diffraction peak positioned at 2θ of 15.2 to 15.5° has a half-width of not more than 0.14°; and
emitting luminescence having a peak in the wavelength range of 490 to 580 nm under excitation by light in the wavelength range of 250 to 500 nm.

2. The fluorescent substance according to claim 1, wherein said x is in the range of 0.001 to 0.5 inclusive.

3. The fluorescent substance according to claim 1, which contains impurity elements in an amount of 0.2% or less.

4. The fluorescent substance according to claim 1, which is in the form of tabular crystals.

5. A light-emitting device, comprising:
a light-emitting element (S1) giving off light in the wavelength range of 250 to 500 nm;
a fluorescent substance (G) according to claim 1;
and
another fluorescent substance (R) which is represented by the following formula (2):
(Sr_{1-x'}Eu_{x'})ₐSi_{b}AlO_{c}N_{d} (2)
in which x', a, b, c and d are numbers satisfying the conditions of 0<x'<0.4, 0.55<a<0.80, 2<b<3, 0.3<c≤0.6 and 4<d<5, respectively; and which emits luminescence having a peak in the wavelength range of 580 to 660 nm under excitation by light given off from said light-emitting element (S1).

6. The device according to claim 5, wherein said x', a, b, c and d are numbers satisfying the conditions of 0.02≤x'≤0.2, 0.66≤a≤0.69, 2.2≤b≤2.4, 0.43≤c≤0.51 and 4.2≤d≤4.3, respectively.

7. A light-emitting device, comprising:
a light-emitting element (S2) giving off light in the wavelength range of 250 to 430 nm;
a fluorescent substance (G) according to claim 1;
another fluorescent substance (R) which is represented by the following formula (2):
(Sr_{1-x'}Eu_{x'})ₐSi_{b}AlO_{c}N_{d} (2)
in which x', a, b, c and d are numbers satisfying the conditions of 0<x'<0.4, 0.55 <a<0.80, 2<b<3, 0.3<c≤0.6 and 4<d<5, respectively; and which emits luminescence having a peak in the wavelength range of 580 to 660 nm under excitation by light given off from said light-emitting element (S2); and
still another fluorescent substance (B) which emits luminescence having a peak in the wavelength range of 400 to 490 nm under excitation by light given off from said light-emitting element (S2).

8. The device according to claim 7, wherein said fluorescent substance (B) is selected from the group consisting of (Ba,Eu)MgAl₁₀O₁₇, (Sr,Ca,Ba,Eu)₁₀(PO₄)₅Cl₂ and (Sr,Eu)Si₉Al₁₉ON₃₁.

9. A process for production of a fluorescent substance (G) which is represented by the following formula (1):
(Sr₁₋ₓEuₓ)_{3-y}Al_{3+z}Si_{13-z}O₂₊ᵤN_{21-w} (1)
in which x, y, z, u and w are numbers satisfying the conditions of 0<x<1, - 0.1≤y≤0.3, -3≤z≤1 and -3<u-w≤1.5, respectively; which gives an X-ray diffraction pattern in which a diffraction peak positioned at 2θ of 15.2 to 15.5° has a half-width of not more than 0.14°; and which emits luminescence having a peak in the wavelength range of 490 to 580 nm under excitation by light in the wavelength range of 250 to 500 nm;
wherein
nitride or carbide of Sr; nitride, oxide or carbide of Al; nitride, oxide or carbide of Si; and oxide, nitride or carbonate of the emission center element Eu are used as materials;
the materials are mixed in increasing order of the added amount; and then
the mixture is fired for 2 hours or more.

10. The process according to claim 9, wherein said mixture is fired for not less than 2.0 hours but not more than 16 hours.

11. The process according to claim 9, wherein said mixture is fired at a temperature of 1500 to 2000°C under a pressure of not less than 5 atmospheres.

12. The process according to claim 9, wherein said mixture is fired under nitrogen gas atmosphere or nitrogen-hydrogen mixed gas atmosphere.

## Patentansprüche

1. Fluoreszierende Substanz, die
durch die folgende Formel (1) wiedergegeben wird:
(Sr₁₋ₓEuₓ)_{3-y}Al_{3-z}Al_{3+z}Si_{13-z}O₂₊ᵤN_{21-w} (1)
worin x, y, z, u und w Zahlen sind, die die Bedingungen 0<x<1, -0,1≤y≤0,3, -3≤z≤1 beziehungsweise -3<u-w≤1,5 erfüllen;
ein Röntgenbeugungsmuster ergibt, bei dem ein Beugungspeak bei 2θ von 15,2 bis 15,5° eine Halbwertsbreite von nicht mehr als 0,14° aufweist; und
Lumineszenz mit einem Peak im Wellenlängenbereich von 490 bis 580 nm bei Anregung mit Licht im Wellenlängenbereich von 250 bis 500 nm emittiert.

2. Fluoreszierende Substanz nach Anspruch 1, worin x im Bereich von 0,001 bis 0,5 einschließlich liegt.

3. Fluoreszierende Substanz nach Anspruch 1, die Verunreinigungselemente in einer Menge von 0,2% oder weniger enthält.

4. Fluoreszierende Substanz nach Anspruch 1, die in Form von Tafelkristallen vorliegt.

5. Lichtemittierende Vorrichtung, umfassend:
ein lichtemittierendes Element (S1), das Licht im Wellenlängenbereich von 250 bis 500 nm abgibt;
eine fluoreszierende Substanz (G) nach Anspruch 1; und
eine weitere fluoreszierende Substanz (R), die durch die folgende Formel (2) wiedergegeben wird:
(Sr_{1-x'}Eu_{x'})ₐSi_{b}AlO_{c}N_{d} (2)
worin x', a, b, c und d Zahlen sind, die die Bedingungen 0<x'<0,4, 0,55<a<0,80, 2<b<3, 0,3<c≤0,6 beziehungsweise 4<d<5 erfüllen; und die Lumineszenz mit einem Peak im Wellenlängenbereich von 580 bis 660 nm bei Anregung mit von dem lichtemittierenden Element (S1) abgegebenem Licht emittiert.

6. Vorrichtung nach Anspruch 5, in der x', a, b, c und d Zahlen sind, die die Bedingungen 0,02≤x'≤0,2, 0,66≤a≤0,69, 2,2≤b≤2,4, 0,43≤c≤0,51 beziehungsweise 4,2≤d≤4,3 erfüllen.

7. Lichtemittierende Vorrichtung, umfassend:
ein lichtemittierendes Element (S2), das Licht im Wellenlängenbereich von 250 bis 430 nm abgibt;
eine fluoreszierende Substanz (G) nach Anspruch 1;
eine weitere fluoreszierende Substanz (R), die durch die folgende Formel (2) wiedergegeben wird:
(Sr_{1-x'}Eu_{x'})ₐSi_{b}AlO_{c}N_{d} (2)
worin x', a, b, c und d Zahlen sind, die die Bedingungen 0<x'<0,4, 0,55<a<0,80, 2<b<3, 0,3<c≤0,6 beziehungsweise 4<d<5 erfüllen; und die Lumineszenz mit einem Peak im Wellenlängenbereich von 580 bis 660 nm bei Anregung mit von dem lichtemittierenden Element (S2) abgegebenem Licht emittiert; und
noch eine weitere fluoreszierende Substanz (B), die Lumineszenz mit einem Peak im Wellenlängenbereich von 400 bis 490 nm bei Anregung mit von dem lichtemittierenden Element (S2) abgegebenem Licht emittiert.

8. Vorrichtung nach Anspruch 7, worin die fluoreszierende Substanz (B) aus der Gruppe ausgewählt ist, die aus (Ba,Eu)MgAl₁₀O₁₇, (Sr,Ca,Ba,Eu)₁₀(PO₄)₅Cl₂ und (Sr,Eu)Si₉Al₁₉ON₃₁ besteht.

9. Verfahren zur Herstellung einer fluoreszierenden Substanz (G), die durch die folgende Formel (1) wiedergegeben wird:
(Sr₁₋ₓEuₓ)_{3-y}Al_{3+z}Si_{13-z}O₂₊ᵤN_{21-w} (1)
worin x, y, z, u und w Zahlen sind, die die Bedingungen 0<x<1, -0,1≤y≤0,3, -3≤z≤ 1 beziehungsweise -3<u-w≤1,5 erfüllen;
die ein Röntgenbeugungsmuster ergibt, bei dem ein Beugungspeak bei 2θ von 15,2 bis 15,5° eine Halbwertsbreite von nicht mehr als 0,14° aufweist; und
die Lumineszenz mit einem Peak im Wellenlängenbereich von 490 bis 580 nm bei Anregung mit Licht im Wellenlängenbereich von 250 bis 500 nm emittiert;
wobei
ein Nitrid oder Carbid von Sr; ein Nitrid, Oxid oder Carbid von Al; ein Nitrid, Oxid oder Carbid von Si; und ein Oxid, Nitrid oder Carbonat des Emissionszentrum-Elements Eu als Materialien verwendet werden;
die Materialien in aufsteigender Reihenfolge der zugegebenen Menge vermischt werden; und dann die Mischung für 2 Stunden oder länger gebrannt wird.

10. Verfahren nach Anspruch 9, bei dem die Mischung für nicht weniger als 2,0 Stunden, jedoch nicht mehr als 16 Stunden gebrannt wird.

11. Verfahren nach Anspruch 9, bei dem die Mischung bei einer Temperatur von 1500 bis 2000°C unter einem Druck von nicht weniger als 5 Atmosphären gebrannt wird.

12. Verfahren nach Anspruch 9, bei dem die Mischung unter einer Stickstoffgas-Atmosphäre oder einer Stickstoff-Wasserstoff-Mischgas-Atmosphäre gebrannt wird.

## Revendications

1. Substance fluorescente
représentée par la formule suivante (1) :
(Sr₁₋ₓEuₓ)_{3-y}Al_{3+z}Si_{13-z}O₂₊ᵤN_{21-w} (1)
dans laquelle x, y, z, u et w sont des nombres satisfaisant aux conditions de 0 < x < 1, -0,1 ≤ y ≤ 0,3, -3 ≤ z ≤ 1 et -3 < u-w ≤ 1,5, respectivement ;
présentant un diagramme de diffraction des rayons X dans lequel un pic de diffraction positionné à 2θ de 15,2 à 15,5° a une largeur à mi-hauteur de pas plus de 0,14° ; et
émettant une luminescence ayant un pic dans la plage de longueur d'onde de 490 à 580 nm sous excitation par une lumière dans la plage de longueur d'onde de 250 à 500 nm.

2. Substance fluorescente selon la revendication 1, dans laquelle ledit x est dans la plage de 0,001 à 0.5 inclus.

3. Substance fluorescente selon la revendication 1, qui contient des éléments d'impureté en une quantité de 0,2 % ou moins.

4. Substance fluorescente selon la revendication 1, qui est sous la forme de cristaux tabulaires.

5. Dispositif électroluminescent, comprenant :
un élément électroluminescent (S1) émettant une lumière dans la plage de longueur d'onde de 250 à 500 nm ;
une substance fluorescente (G) selon la revendication 1 ;
et
une autre substance fluorescente (R) qui est représentée par la formule suivante (2) :
(Sr_{1-x'}Eu_{x'})ₐSi_{b}AlO_{c}N_{d} (2)
dans laquelle x', a, b, c et d sont des nombres satisfaisant aux conditions de 0 < x' < 0,4, 0,55 < a < 0,80, 2 < b < 3, 0,3 < c ≤ 0,6 et 4 < d < 5, respectivement ; et qui émet une luminescence ayant un pic dans la plage de longueur d'onde de 580 à 660 nm sous excitation par une lumière émise par ledit élément électroluminescent (S1).

6. Dispositif selon la revendication 5, dans lequel lesdits x', a, b, c et d sont des nombres satisfaisant aux conditions de 0,02 ≤ x' ≤ 0,2, 0,66 ≤ a ≤ 0,69, 2,2 ≤ b ≤ 2,4, 0,43 ≤ c ≤ 0,51 et 4,2 ≤ d ≤ 4,3, respectivement.

7. Dispositif électroluminescent, comprenant :
un élément électroluminescent (S2) émettant une lumière dans la plage de longueur d'onde de 250 à 430 nm ;
une substance fluorescente (G) selon la revendication 1 ;
une autre substance fluorescente (R) qui est représentée par la formule suivante (2) :
(Sr_{1-x'}Eu_{x'})ₐSi_{b}AlO_{c}N_{d} (2)
dans laquelle x', a, b, c et d sont des nombres satisfaisant aux conditions de 0 < x' < 0,4, 0,55 < a < 0,80, 2 < b < 3, 0,3 < c ≤ 0,6 et 4 < d < 5, respectivement ; et qui émet une luminescence ayant un pic dans la plage de longueur d'onde de 580 à 660 nm sous excitation par une lumière émise par ledit élément électroluminescent (S2) ; et
une autre substance fluorescente supplémentaire (B) qui émet une luminescence ayant un pic dans la plage de longueur d'onde de 400 à 490 nm sous excitation par une lumière émise par ledit élément électroluminescent (S2).

8. Dispositif selon la revendication 7, dans lequel ladite substance fluorescente (B) est choisie dans le groupe constitué de (Ba,Eu)MgAl₁₀O₁₇, (Sr,Ca,Ba,Eu)₁₀(PO₄)₅Cl₂ et (Sr,Eu)Si₉Al₁₉ON₃₁.

9. Procédé de production d'une substance fluorescente (G) qui est représentée par la formule suivante (1) :
(Sr₁₋ₓEuₓ)_{3-y}Al_{3+z}Si_{13-z}O₂₊ᵤN_{21-w} (1)
dans laquelle x, y, z, u et w sont des nombres satisfaisant aux conditions de 0 < x < 1, -0,1 ≤ y ≤ 0,3, -3 ≤ z ≤ 1 et -3 < u-w ≤ 1,5, respectivement ; qui présente un diagramme de diffraction des rayons X dans lequel un pic de diffraction positionné à 2θ de 15,2 à 15,5° a une largeur à mi-hauteur de pas plus de 0,14° ; et qui émet une luminescence ayant un pic dans la plage de longueur d'onde de 490 à 580 nm sous excitation par une lumière dans la plage de longueur d'onde de 250 à 500 nm ;
dans lequel
le nitrure ou carbure de Sr ; le nitrure, oxyde ou carbure de Al ; le nitrure, oxyde ou carbure de Si ; et l'oxyde, nitrure ou carbonate de l'élément central d'émission Eu sont utilisés en tant que matériaux ;
les matériaux sont mélangés dans l'ordre croissant de la quantité ajoutée ; et ensuite le mélange est cuit pendant 2 heures ou plus.

10. Procédé selon la revendication 9, dans lequel ledit mélange est cuit pendant pas moins de 2,0 heures mais pas plus de 16 heures.

11. Procédé selon la revendication 9, dans lequel ledit mélange est cuit à une température de 1500 à 2000 °C sous une pression de pas moins de 5 atmosphères.

12. Procédé selon la revendication 9, dans lequel ledit mélange est cuit sous une atmosphère de gaz d'azote ou une atmosphère de gaz mixte azote-hydrogène.
